# DEMANDE DE BREVET EUROPEEN

(11) **EP 1 837 910 A1**
(43) Date de publication de la demande: **26.09.2007**
(21) Numéro de dépôt: 07300867.4
(22) Date de dépôt: 16.03.2007
(51) Int. Cl.: H01L 23/485, H01L 21/60

(54) **Puce de circuits integrés à plots externes decalés et procédé de fabrication d'une telle puce.**

(30) Priorité: 21.03.2006 FR 0602469
(71) Demandeur: STMICROELECTRONICS SA, 92120 Montrouge (FR)
(72) Inventeur: Le Briz, Olivier, 38470, SAINT-GERVAIS (FR); Marsanne, Sébastien, 38240, MEYLAN (FR); Martin, Laurence, 38100, GRENOBLE (FR); Groce, Giuseppe, LC, MONTICELLO BRIANZA (IT)
(74) Mandataire: Zapalowicz, Francis

(57) **Abrégé**

Puce de circuits intégrés et procédé pour la fabrication d'une telle puce, dans lesquels des premiers moyens de connexion électrique (4) sont placés sur une couche sous-jacente (3) et recouverts par une couche intermédiaire diélectrique (5); des seconds moyens de connexion électrique (7) sont placés sur ladite couche intermédiaire diélectrique (5) et recouverts par une couche superficielle diélectrique (8) ; des plots de connexion électrique extérieure (12) sont placés sur ladite couche superficielle diélectrique (8) et s'étendent sélectivement au-dessus d'au moins des premiers moyens de connexion électrique ; et des vias (13) traversent ladite couche superficielle diélectrique et ladite couche intermédiaire diélectrique et sont placés entre lesdits premiers moyens de connexion électrique et lesdits plots de connexion électrique extérieure.

## Description

La présente invention concerne le domaine général des dispositifs semi-conducteurs et plus particulièrement des puces de circuits intégrés équipées de plots de contact électrique externes en saillie.

Dans une application, de telles puces sont destinées à être montées sur des plaques, de telle sorte que leurs plots de contact externe établissent des liaisons électriques sur ces plaques. Pour cela, lors du montage, on presse les puces en direction de plaques munies d'une couche diélectrique présentant en suspension des particules en un matériau conducteur de l'électricité, de telle sorte que les particules situées entre les plaques et les faces d'extrémité ou frontales des plots de contact externe établissent les liaisons électriques.

Dans une autre application, les plots de contact externe sont destinés à être soudés à l'extrémité de pistes de connexion électrique en porte-à-faux portées par des bandes flexibles. Pour réaliser un tel montage, les extrémités de pistes de connexion électrique sont pressées sur la face supérieure des plots de contact des puces, sous une température relativement élevée.

Actuellement, partant d'une puce comprenant une couche inférieure sur laquelle sont formés des plots internes et une couche superficielle qui recouvre ces derniers et qui présente des bossages de surface dans les zones de ces plots internes, on réalise des ouvertures dans la couche superficielle, au-dessus des plots internes, et on réalise les plots de contact externe et en saillie, par un dépôt par croissance d'un matériau conducteur de l'électricité dans les ouvertures de la couche superficielle et des ouvertures d'un masque provisoire, plus grandes que les ouvertures de la couche superficielle. Il s'ensuit que les faces d'extrémité des plots de contact externe obtenus présentent une partie centrale en creux et un rebord périphérique correspondant au rebord de la couche superficielle entourant l'ouverture correspondante ménagée dans cette couche.

Une telle disposition engendre un affaiblissement de la couche superficielle autour des plots de contact externe et un risque d'apparition de fissures lors des assemblages précités qui doit être effectué sous des pressions relativement élevées du fait en particulier de l'existence desdites parties en creux, ces fissures étant propices à l'apparition d'une corrosion interne de la puce. En outre, comme les plots internes sont en général en aluminium et que les plots de contact externe sont en général en or, il existe un risque de réactions électrochimiques susceptibles, par gonflement de la matière, de détériorer les liaisons électriques et d'accroître encore le risque d'apparition de fissures.

La présente invention a notamment pour but d'améliorer la résistance mécanique des puces de circuits intégrés à plots de contact externe en saillie, tant à la pression qu'à la température, notamment lors des opérations de connexion desdits plots à d'autres moyens de connexion.

La présente invention a tout d'abord pour objet une puce de circuits intégrés.

Selon l'invention, cette puce comprend : des premiers moyens de connexion électrique placés sur une couche sous-jacente et recouverts par une couche intermédiaire diélectrique ; des seconds moyens de connexion électrique placés sur ladite couche intermédiaire diélectrique et recouverts par une couche superficielle diélectrique ; des plots de connexion électrique extérieure placés sur ladite couche superficielle diélectrique, s'étendant sélectivement au-dessus d'au moins des premiers moyens de connexion électrique ; et des vias de connexion électrique formés dans des trous traversant ladite couche superficielle diélectrique et ladite couche intermédiaire diélectrique et placés entre lesdits premiers moyens de connexion électrique et lesdits plots de connexion électrique extérieure.

Selon l'invention, lesdits plots de connexion électrique sont de préférence réalisés sur des zones plates de ladite couche superficielle diélectrique (8).

Selon l'invention, ladite puce comprend en outre des moyens auxiliaires de connexion électrique sur ladite couche sous-jacente, passant au-dessous desdits plots de connexion électrique.

La présente invention a également pour objet une procédé de fabrication d'une puce de circuits intégrés.

Ce procédé consiste : à réaliser des premiers moyens de connexion électrique sur une couche sous-jacente ; à réaliser une couche intermédiaire diélectrique sur ladite couche sous-jacente et recouvrant lesdits premiers moyens de connexion électrique ; à réaliser des seconds moyens de connexion électrique sur ladite couche intermédiaire diélectrique ; à réaliser une couche superficielle diélectrique sur ladite couche intermédiaire diélectrique et recouvrant lesdits seconds moyens de connexion électrique ; à réaliser des trous traversant ladite couche superficielle diélectrique et ladite couche intermédiaire diélectrique découvrant sélectivement des zones des premiers moyens de connexion électrique ; et à réaliser des vias de connexion électrique dans lesdits trous et former des plots de connexion électrique sur ladite couche superficielle diélectrique et s'étendant au-dessus des vias.

Selon l'invention, le procédé peut avantageusement consister, après avoir réaliser lesdits trous, à réaliser un masque sur ladite couche superficielle diélectrique présentant des trous correspondant aux plots à obtenir et à réaliser lesdits vias de connexion électrique et lesdits plots de connexion électrique par une opération de dépôt par croissance d'un métal.

Selon l'invention, le procédé peut avantageusement consister à réaliser lesdits plots de connexion électrique sur des zones plates de ladite couche superficielle diélectrique.

La présente invention sera mieux comprise à l'étude d'une puce de circuits intégrés et de son mode de fabrication, décrits à titre d'exemples non limitatifs et illustrés par le dessin sur lequel :
- La figure 1 représente une coupe partielle d'une puce de circuits intégrés selon l'invention ;
- La figure 2 représente la puce de la figure 1 dans une étape ultérieure de fabrication ;
- Et la figure 3 représente une vue de dessus partielle de la puce de la figure 1.

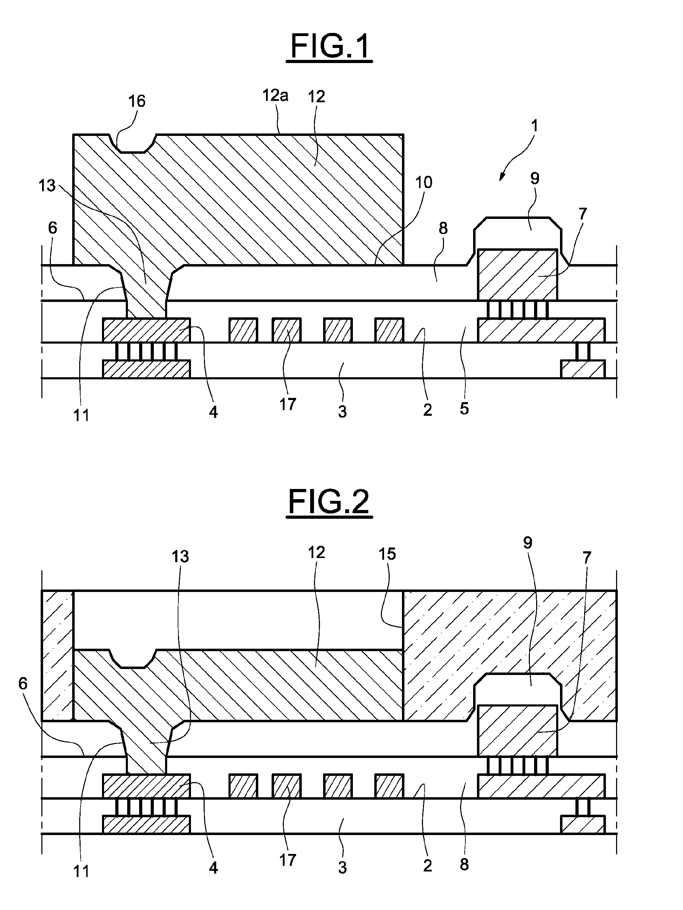

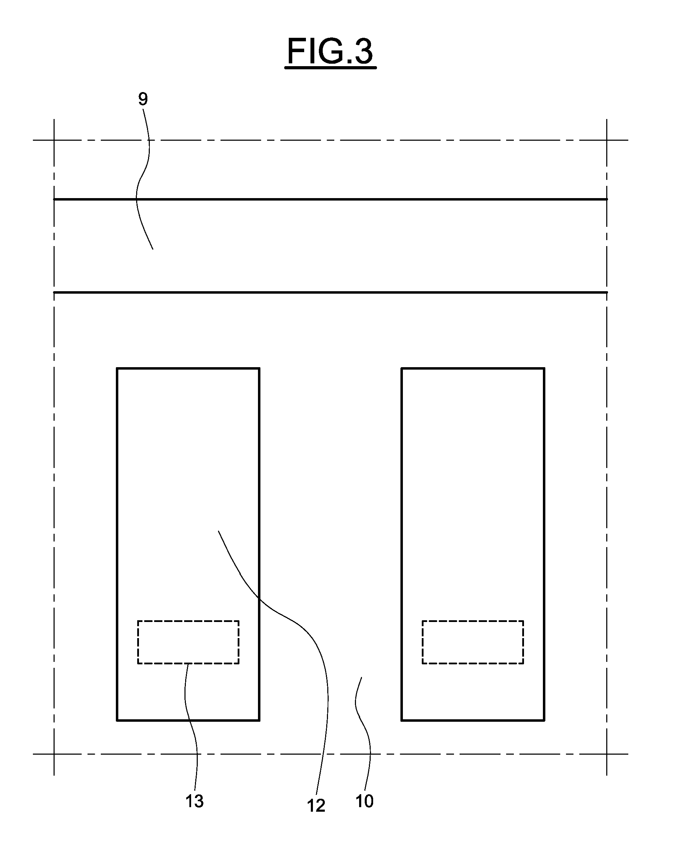

En se reportant aux figures 1 et 3, on peut voir qu'on a représenté une puce de circuits intégrés 1 qui comprend, sur la surface planarisée 2 d'une couche sous-jacente 3 en dessous de laquelle sont réalisés des circuits ou composants électroniques intégrés, des premiers moyens de connexion électrique constitués par des plots ou pistes enterrés 4 et une couche intermédiaire diélectrique 5 formée sur la surface 2 de la couche sous-jacente 3 et recouvrant les plots ou pistes enterrés 4.

Sur la surface planarisée 6 de la couche intermédiaire diélectrique 5, la puce 1 comprend des seconds moyens de connexion électrique constitués par des plots ou pistes enterrés 7 et une couche superficielle diélectrique 8 formée sur la surface 6 de la couche intermédiaire diélectrique 5 et recouvrant les plots ou pistes enterrés 7. La couche superficielle diélectrique 8 présente des bossages 9 enveloppant par le dessus les plots ou pistes enterrés 7.

Les plots ou pistes enterrés 4 sont décalés horizontalement par rapport aux bossages 9 de telle sorte que la surface externe de la couche superficielle diélectrique 8 présente des zones 10 plates s'étendant au-dessus des plots ou pistes enterrés 4, latéralement aux bossages 9.

La couche superficielle diélectrique 8 présente des trous ou ouvertures 11 qui sont formés au travers de la couche intermédiaire diélectrique 5 et de la couche superficielle diélectrique 8 et qui, respectivement, découvrent partiellement les plots ou pistes enterrés 4.

La puce 1 comprend en outre des plots de connexion ou de contact électrique extérieur en saillie 12 qui sont formés sur les zones plates 10 et passent au-dessus des trous 11 en les recouvrant complètement et qui sont connectés, verticalement, respectivement aux plots ou pistes enterrés 4 par des vias 13 de connexion électrique constitués par un matériau remplissant les trous 11, ces vias s'étendant entre les plots ou pistes enterrés 4 et les plots de connexion électrique extérieure 12.

Ainsi, les plots ou pistes enterrés 4, les vias 13 qui forment des colonnes et les plots extérieurs en saillie 12 constituent une construction physique rigide et forte, ancrée en profondeur dans la puce de circuits intégrés 1.

Les plots de connexion électrique extérieure 12 se présentent sous la forme de blocs parallélépipédiques dont la face supérieure est plate sur quasiment toute sa surface.

Dans la variante représentée, les plots de connexion électrique extérieure 12 sont allongés et les vias sont allongés transversalement à ces plots 12, sans atteindre les grands côtés de ces derniers. Avantageusement, la longueur des plots de connexion électrique extérieure 12 est largement supérieure à la largeur des vias de connexion électrique 13.

Pour fabriquer la puce 1 qui vient d'être décrite, on peut procéder de la manière suivante, telle qu'illustrée sur la figure 2, en utilisant les modes opératoires connus dans le domaine de la microélectronique.

Disposant d'une puce 1 fabriquée jusqu'à la couche superficielle diélectrique 8, on réalise les trous 11 par exemple par gravure, ces trous étant légèrement convergents en direction des plots ou pistes enterrés 4.

Ensuite, on dépose sur la surface de la couche superficielle diélectrique 8 une fine couche (UBM) d'un ou plusieurs matériaux favorisant la création des plots 12 et des vias 13, cette couche n'étant pas visible sur le dessin.

Ensuite, on forme un masque 14 sur la couche superficielle diélectrique 8 dans lequel sont réalisées des ouvertures 15 correspondant aux plots extérieurs à réaliser.

Puis, on réalise les plots de connexion électrique 12 et les vias de connexion électrique 13 par une seule opération de dépôt par croissance du métal choisi.

Enfin, on procède à l'enlèvement du masque 14 et de la fine couche (UBM) sur la surface de la couche superficielle diélectrique 8, tout autour des plots de connexion électrique 12.

La structure de la puce 1 telle qu'elle vient d'être décrite présente notamment les avantages suivants.

Les plots de connexion électrique 12 présentent des faces frontales 12a plates, à l'exception de parties 16 légèrement en creux situées au-dessus des vias 13, ces parties en creux 16 étant très réduites par rapport à la surface totale des faces frontales 12a. Ainsi, les faces frontales plates 12a sont propices à toutes connexions à plat sur ces faces, sans engendrer de difficultés.

Les plots de connexion électrique 12 sont formés sur une structure en couches horizontales superposées et sur une zone 10 plate. Ainsi, une telle construction est capable de subir des pressions relativement importantes exercées sur leurs faces frontales 12a notamment lors de la mise en place de connexions sur ces dernières, sans engendrer de détérioration.

Les plots de connexion électrique 12 et les plots ou pistes enterrés 7, réalisés dans un niveau métallique supérieur à celui des plots ou pistes enterrés 4 reliés à ces plots 12, sont structurellement indépendants. Ainsi, la section et notamment l'épaisseur des plots ou pistes enterrés 7 du dernier niveau métallique peuvent être choisies indépendamment et donc uniquement en fonction des besoins électriques associés.

Par ailleurs, des pistes de connexion électriques 17, passant en dessous des plots de connexion électrique 12, peuvent être réalisées sur la couche sous-jacente 3 et utilisées pour des besoins de connexions internes à la puces.

Dans un exemple particulier, les plots ou pistes enterrés 4 peuvent être en aluminium (A1), la fine couche (UBM) peut être en Titane/tungstène (TiW) recouvert de poudre d'or (Au) et les plots de connexion électriques 12 et les vias de connexion électriques 13 peuvent être en or (Au). Bien entendu, d'autres métaux que ceux mentionnés ci-dessus pourraient être utilisés.

A titre d'exemple également, l'épaisseur des plots ou pistes enterrés 4 peut être comprise entre 0,5 et 0,9 microns, l'épaisseur de la couche intermédiaire 5 au-dessus de ces plots ou pistes 4 peut être comprise entre 0,6 et 0,8 microns, l'épaisseur de la couche superficielle 8 peut être comprise entre 0,8 et 1,2 microns et la surface couverte par les plots de connexion extérieure peut être 5 à 15 fois plus grande que la surface couverte par les vias de connexion électrique 13, cette dernière pouvant être comprise entre 100 et 200 microns carrés. Par ailleurs, l'épaisseur des plots ou pistes enterrés 7 peut être comprise entre 0,8 et 3 microns.

La présente invention ne se limite pas aux exemples décrits ci-dessus. Des variantes de réalisation sont possibles sans sortir du cadre des revendications annexées.

## Revendications

1. Puce de circuits intégrés, **caractérisée par le fait qu'**elle comprend :
des premiers moyens de connexion électrique (4) placés sur une couche sous-jacente (3) et recouverts par une couche intermédiaire diélectrique (5) ;
des seconds moyens de connexion électrique (7) placés sur ladite couche intermédiaire diélectrique (5) et recouverts par une couche superficielle diélectrique (8) ;
des plots de connexion électrique extérieure (12) placés sur ladite couche superficielle diélectrique (8), s'étendant sélectivement au-dessus d'au moins des premiers moyens de connexion électrique ;
et des vias de connexion électrique (13) formés dans des trous (11) traversant ladite couche superficielle diélectrique et ladite couche intermédiaire diélectrique et placés entre lesdits premiers moyens de connexion électrique et lesdits plots de connexion électrique extérieure.

2. Puce selon la revendication 1, **caractérisée par le fait que** lesdits plots de connexion électrique (12) sont réalisés sur des zones plates (10) de ladite couche superficielle diélectrique (8).

3. Puce selon l'une des revendications, **caractérisée par le fait qu'**elle comprend des moyens auxiliaires de connexion électrique (17) sur ladite couche sous-jacente (3), passant au-dessous desdits plots de connexion électrique (12).

4. Procédé de fabrication d'une puce de circuits intégrés, **caractérisé par le fait qu'**il consiste :
A réaliser des premiers moyens de connexion électrique (4) sur une couche sous-jacente ;
A réaliser une couche intermédiaire diélectrique (5) sur ladite couche sous-jacente et recouvrant lesdits premiers moyens de connexion électrique ;
A réaliser des seconds moyens de connexion électrique (7) sur ladite couche intermédiaire diélectrique ;
A réaliser une couche superficielle diélectrique (8) sur ladite couche intermédiaire diélectrique et recouvrant lesdits seconds moyens de connexion électrique ;
A réaliser des trous (11) traversant ladite couche superficielle diélectrique et ladite couche intermédiaire diélectrique découvrant sélectivement des zones des premiers moyens de connexion électrique ;
Et à réaliser des vias de connexion électrique (13) dans lesdits trous et former des plots de connexion électrique (12) sur ladite couche superficielle diélectrique et s'étendant au-dessus des vias.

5. Procédé selon la revendication 4, **caractérisé par le fait qu'**il consiste, après avoir réaliser lesdits trous, à réaliser un masque sur ladite couche superficielle diélectrique présentant des trous correspondant aux plots à obtenir et à réaliser lesdits vias de connexion électrique et lesdits plots de connexion électrique par une opération de dépôt par croissance d'un métal.

6. Procédé selon l'une des revendications 4 et 5, **caractérisé par le fait qu'**il consiste à réaliser lesdits plots de connexion électrique (12) sur des zones plates (10) de ladite couche superficielle diélectrique (8).
